# FASCICULE DE BREVET EUROPEEN

(11) **EP 3 319 916 B1**
(45) Date de publication et mention de la délivrance du brevet: **28.10.2020**
(21) Numéro de dépôt: 16742357.3
(22) Date de dépôt: 30.06.2016
(51) Int. Cl.: C03C 17/36

(54) **MATERIAU MUNI D'UN EMPILEMENT A PROPRIETES THERMIQUES**
MATERIAL MIT EINEM STAPEL MIT WÄRMEEIGENSCHAFTEN
MATERIAL PROVIDED WITH A STACK HAVING THERMAL PROPERTIES

(30) Priorité: 08.07.2015 FR 1556481
(43) Date de publication de la demande: 16.05.2018
(73) Titulaire: SAINT-GOBAIN GLASS FRANCE, 92400 Courbevoie (FR)
(72) Inventeur: LORENZZI, Jean Carlos, 75011 Paris (FR); MERCADIER, Nicolas, 75014 Paris (FR)
(74) Mandataire: Saint-Gobain Recherche
(86) Numéro de dépôt international: PCT/FR2016/051651
(87) Numéro de publication internationale: WO 2017/006029

(56) Documents cités:
- WO-A1-2012/093238
- WO-A1-2013/104438
- WO-A1-2014/095388
- FR-A1- 2 859 721

## Description

L'invention concerne un matériau comprenant un substrat transparent revêtu d'un empilement de couches minces comprenant plusieurs couches fonctionnelles pouvant agir sur le rayonnement solaire et/ou le rayonnement infrarouge. L'invention concerne également les vitrages comprenant ces matériaux ainsi que l'utilisation de tels matériaux pour fabriquer des vitrages d'isolation thermique et/ou de protection solaire.

Ces vitrages peuvent être destinés aussi bien à équiper les bâtiments que les véhicules, en vue notamment de diminuer l'effort de climatisation et/ou d'empêcher une surchauffe excessive, vitrages dits « de contrôle solaire » et/ou diminuer la quantité d'énergie dissipée vers l'extérieur, vitrages dits « bas émissifs » entraînée par l'importance toujours croissante des surfaces vitrées dans les bâtiments et les habitacles de véhicules.

Des vitrages comprenant des substrats transparents revêtus d'un empilement de couches minces comprenant trois couches fonctionnelles métalliques, chacune disposée entre deux revêtements diélectriques ont été proposés afin d'améliorer la protection solaire tout en conservant une transmission lumineuse élevée. Ces empilements sont généralement obtenus par une succession de dépôts effectués par pulvérisation cathodique éventuellement assistée par champ magnétique. Ces vitrages sont qualifiés de sélectifs car ils permettent :
- de diminuer la quantité d'énergie solaire pénétrant à l'intérieur des bâtiments en présentant un faible facteur solaire (FS ou g),
- de garantir une transmission lumineuse élevée.

Selon l'invention, on entend :
- facteur solaire « g », le rapport en pourcentage entre l'énergie totale entrant dans le local à travers le vitrage et l'énergie solaire incidente,
- sélectivité « s », le rapport entre la transmission lumineuse et le facteur solaire TL/g.

La demande de brevet EP 0 645 352 divulgue par exemple un substrat transparent comprenant un empilement de couches minces comportant au moins trois couches fonctionnelles métalliques à base d'argent (ci-après couche d'argent). Les épaisseurs des couches d'argent augmentent en fonction de l'éloignement du substrat. Les vitrages comprenant ces substrats, bien que présentant un aspect esthétique agréable, ne présentent pas une sélectivité supérieure à 2,0 et/ou un facteur solaire inférieur à 35 % pour une transmission lumineuse d'environ 70 %. Or, il est extrêmement difficile de conserver à la fois une bonne sélectivité et des couleurs en transmission et en réflexion esthétiquement acceptables avec notamment un aspect du vitrage vu de l'intérieur de couleur neutre.

L'objectif de l'invention est de développer un matériau présentant des propriétés de contrôle solaire améliorées et notamment des valeurs de facteur solaire inférieures ou égales à 34 % pour une transmission lumineuse d'au moins 65 %. Selon l'invention, on cherche donc à minimiser le facteur solaire et à augmenter la sélectivité, tout en gardant une transmission lumineuse élevée pour permettre une bonne isolation et une bonne vision.

La complexité des empilements comprenant trois couches fonctionnelles rend difficile l'amélioration de ces performances thermiques et des propriétés en transmission sans nuire aux autres propriétés de l'empilement.

Le but de l'invention est donc de pallier ces inconvénients en mettant au point un substrat comprenant un empilement comportant au moins trois couches d'argent qui présente une haute sélectivité, c'est-à-dire un rapport TL/g le plus élevé possible pour une valeur de TL donnée, tout en garantissant un aspect, notamment en réflexion extérieure, en réflexion intérieure et en transmission qui soit agréable à l'œil. L'aspect agréable à l'œil se traduit par l'obtention de couleurs, tant de l'extérieur que de l'intérieur, plus neutre, dans les bleu-vert et qui en outre varie peu suivant l'angle d'observation.

Le demandeur a découvert de manière surprenante qu'en combinant l'utilisation de trois couches d'argent d'épaisseur croissante et de matériaux diélectriques haut indice dans chaque revêtement diélectrique selon des proportions importantes, on augmente considérablement la sélectivité tout en conservant des couleurs neutres pour les empilements par rapport aux solutions existantes.

L'invention a pour objet un matériau tel que défini dans la revendication 1. Ce matériau un substrat transparent revêtu d'un empilement de couches minces comportant successivement à partir du substrat une alternance de trois couches métalliques fonctionnelles à base d'argent dénommées en partant du substrat première, deuxième et troisième couches fonctionnelles, les épaisseurs des couches métalliques fonctionnelles en partant du substrat augmentent en fonction de l'éloignement du substrat, et de quatre revêtements diélectriques dénommés en partant du substrat M1, M2, M3 et M4, chaque revêtement diélectrique comportant au moins une couche diélectrique, de manière à ce que chaque couche métallique fonctionnelle soit disposée entre deux revêtements diélectriques, caractérisé en ce que :
- les revêtements diélectriques M1, M2, M3 et M4 ont chacun une épaisseur optique Eo1, Eo2, Eo3 et Eo4,
- chaque revêtement diélectrique comprend au moins une couche diélectrique haut indice dont l'indice de réfraction est d'au moins 2,15 et dont l'épaisseur optique supérieure à 20 nm,
- la somme des épaisseurs optiques de toutes les couches diélectrique haut indice d'un même revêtement diélectrique est dénommée selon le revêtement diélectrique concerné Eohi1, Eohi2, Eohi3 ou Eohi4
- chaque revêtement diélectrique satisfait la relation suivante : Eohi1/Eo1 > 0,30,
   Eohi2/Eo2 > 0,30,
   Eohi3/Eo3 > 0,30,
   Eohi4/Eo4 > 0,30.
- le rapport de l'épaisseur de la deuxième couche métallique sur l'épaisseur de la première couche métallique fonctionnelle est compris entre 1,20 et 2,00, en incluant ces valeurs, et
- le rapport de l'épaisseur de la troisième couche métallique sur l'épaisseur de la deuxième couche métallique fonctionnelle est compris entre 1,20 et 1,80, en incluant ces valeurs.

La solution de l'invention représente un excellent compromis entre les performances optiques, thermiques, la transparence et l'aspect esthétique.

L'invention concerne également :
- le procédé d'obtention d'un matériau selon l'invention,
- le vitrage comprenant au moins un matériau selon l'invention,
- l'utilisation d'un vitrage selon l'invention en tant que vitrage de contrôle solaire pour le bâtiment,
- un bâtiment comprenant un vitrage selon l'invention.

En modulant les épaisseurs des couches fonctionnelles et des revêtements diélectriques, la transparence du vitrage peut être contrôlée de façon à obtenir des valeurs de TL de l'ordre de 65 %. Mais l'avantage majeur de l'invention est que l'obtention de l'aspect visuel satisfaisant avec notamment des couleurs en réflexion extérieure particulières ainsi que des valeurs de réflexion extérieure suffisamment basses ne s'opèrent pas au détriment des performances de protection solaire. D'excellentes performances énergétiques sont obtenues sans nécessiter de modifications substantielles des autres paramètres de l'empilement tels que la nature, l'épaisseur et la séquence des couches le constituant.

Les caractéristiques préférées qui figurent dans la suite de la description sont applicables aussi bien au procédé selon l'invention que, le cas échéant, aux produits, c'est-à-dire aux matériaux ou aux vitrages comprenant le matériau.

Toutes les caractéristiques lumineuses présentées dans la description sont obtenues selon les principes et méthodes décrits dans la norme européenne EN 410 se rapportant à la détermination des caractéristiques lumineuses et solaires des vitrages utilisés dans le verre pour la construction.

De manière conventionnelle, les indices de réfraction sont mesurés à une longueur d'onde de 550 nm. Les facteurs de transmission lumineuse TL et de réflexion lumineuse RL sont mesurés sous l'illuminant D65 avec un champ de vision de 2°.

Sauf indication contraire, toutes les valeurs et gammes de valeurs des caractéristiques optiques et thermiques sont données pour un vitrage double constitué d'un substrat de type verre sodo-calcique ordinaire de 6 mm portant l'empilement de couches minces, d'un espace intercalaire de 16 mm rempli d'argon à raison de 90 % et d'air à raison de 10 % et d'un autre substrat de type verre sodo-calcique, non-revêtu, d'une épaisseur de 4 mm. Le substrat revêtu est placé de sorte que l'empilement de couches minces se trouve en face 2 du vitrage. La réflexion extérieure Rext. est observée du côté du substrat comprenant l'empilement, tandis que la réflexion observée du côté du substrat ne comprenant pas l'empilement est désignée comme la réflexion intérieure. La transmission lumineuse (TL) des substrats de type verre sodo-calcique ordinaire, sans empilement est supérieure à 89 %, de préférence de 90 %.

Sauf mention contraire, les épaisseurs évoquées dans le présent document sans autres précisions sont des épaisseurs physiques, réelles ou géométriques dénommées Ep et sont exprimées en nanomètres (et non pas des épaisseurs optiques). L'épaisseur optique Eo est définie comme l'épaisseur physique de la couche considérée multipliée par son indice de réfraction à la longueur d'onde de 550 nm : Eo = n*Ep. L'indice de réfraction étant une valeur adimensionnelle, on peut considérer que l'unité de l'épaisseur optique est celle choisie pour l'épaisseur physique.

Si un revêtement diélectrique est composé de plusieurs couches diélectriques, l'épaisseur optique du revêtement diélectrique correspond à la somme des épaisseurs optiques des différentes couches diélectriques constituant le revêtement diélectrique.

Dans toute la description le substrat selon l'invention est considéré posé horizontalement. L'empilement de couches minces est déposé au-dessus du substrat. Le sens des expressions « au-dessus » et « en-dessous » et « inférieur » et « supérieur » est à considérer par rapport à cette orientation. A défaut de stipulation spécifique, les expressions « au-dessus » et « en-dessous » ne signifient pas nécessairement que deux couches et/ou revêtements sont disposés au contact l'un de l'autre. Lorsqu'il est précisé qu'une couche est déposée « au contact » d'une autre couche ou d'un revêtement, cela signifie qu'il ne peut y avoir une (ou plusieurs) couche(s) intercalée(s) entre ces deux couches (ou couche et revêtement).

Au sens de la présente invention, les qualifications « première », « deuxième », « troisième » et « quatrième » pour les couches fonctionnelles ou les revêtements diélectriques sont définies en partant du substrat porteur de l'empilement et en se référant aux couches ou revêtements de même fonction. Par exemple, la couche fonctionnelle la plus proche du substrat est la première couche fonctionnelle, la suivante en s'éloignant du substrat est la deuxième couche fonctionnelle, etc.

L'invention concerne également un vitrage comprenant un matériau selon l'invention. De manière conventionnelle, les faces d'un vitrage sont désignées à partir de l'extérieur du bâtiment et en numérotant les faces des substrats de l'extérieur vers l'intérieur de l'habitacle ou du local qu'il équipe. Cela signifie que la lumière solaire incidente traverse les faces dans l'ordre croissant de leur numéro.

De préférence, l'empilement est déposé par pulvérisation cathodique assistée par un champ magnétique (procédé magnétron). Selon ce mode de réalisation avantageux, toutes les couches de l'empilement sont déposées par pulvérisation cathodique assistée par un champ magnétique.

L'invention concerne également le procédé d'obtention d'un matériau selon l'invention, dans lequel on dépose les couches de l'empilement par pulvérisation cathodique magnétron.

Les couches fonctionnelles métalliques à base d'argent comprennent au moins 95,0 %, de préférence au moins 96,5 % et mieux au moins 98,0 % en masse d'argent par rapport à la masse de la couche fonctionnelle. De préférence, la couche métallique fonctionnelle à base d'argent comprend moins de 1,0 % en masse de métaux autres que de l'argent par rapport à la masse de la couche métallique fonctionnelle à base d'argent.

La caractéristique selon laquelle les épaisseurs des couches métalliques fonctionnelles en partant du substrat augmentent signifie que l'épaisseur de la troisième couche métallique fonctionnelle est supérieure à celle de la deuxième couche métallique fonctionnelle et en ce que l'épaisseur de la deuxième couche métallique fonctionnelle est supérieure à celle de la première couche métallique fonctionnelle. L'augmentation d'épaisseur entre deux couches fonctionnelles successives est par ordre de préférence croissant, supérieure à 2 nm, supérieure à 3 nm, supérieure à 4 nm.

Selon des modes de réalisation avantageux de l'invention, les couches métalliques fonctionnelles satisfont une ou plusieurs des conditions suivantes :
- les trois couches métalliques fonctionnelles correspondent à la première, à la deuxième et à la troisième couche fonctionnelle métallique définies en partant du substrat,
- le rapport de l'épaisseur de la deuxième couche métallique sur l'épaisseur de la première couche métallique fonctionnelle est, par ordre de préférence croissant, compris entre 1,20 et 1,80 entre 1,40 et 1,60 en incluant ces valeurs, et/ou
- le rapport de l'épaisseur de la troisième couche métallique sur l'épaisseur de la deuxième couche métallique fonctionnelle est, par ordre de préférence croissant, compris entre 1,20 et 1,60, entre 1,20 et 1,40 en incluant ces valeurs, et/ou
- l'épaisseur de la première couche métallique fonctionnelle est, par ordre de préférence croissant, comprise entre 6 et 12 nm, entre 7 et 11 nm, entre 8 et 10 nm, et/ou
- l'épaisseur de la seconde couche métallique fonctionnelle est, par ordre de préférence croissant, comprise entre 11 et 20 nm, entre 12 et 18 nm, entre 13 et 15 nm, et/ou
- l'épaisseur de la troisième couche métallique fonctionnelle est, par ordre de préférence croissant, comprise entre 15 et 22 nm, entre 16 et 20 nm, entre 17 et 19 nm, et/ou
- l'épaisseur totale des couches métalliques fonctionnelles est comprise entre 30 et 50 nm en incluant ces valeurs, de préférence entre 35 et 45 nm.

Ces plages d'épaisseur pour les couches métalliques fonctionnelles sont les plages pour lesquelles les meilleurs résultats sont obtenus pour une transmission lumineuse en double vitrage d'au moins 65 %, une réflexion lumineuse et un facteur solaire bas. On obtient ainsi une sélectivité élevée et des couleurs neutres.

L'empilement peut comprendre en outre au moins une couche de blocage située au contact d'une couche fonctionnelle.

Les couches de blocage ont traditionnellement pour fonction de protéger les couches fonctionnelles d'une éventuelle dégradation lors du dépôt du revêtement antireflet supérieur et lors d'un éventuel traitement thermique à haute température, du type recuit, bombage et/ou trempe.

Les couches de blocage sont choisies parmi les couches métalliques à base d'un métal ou d'un alliage métallique, les couches de nitrure métallique, les couches d'oxyde métallique et les couches d'oxynitrure métallique d'un ou plusieurs éléments choisis parmi le titane, le nickel, le chrome et le niobium telles que Ti, TiN, TiOx, Nb, NbN, Ni, NiN, Cr, CrN, NiCr, NiCrN. Lorsque ces couches de blocage sont déposées sous forme métallique, nitrurée ou oxynitrurée, ces couches peuvent subir une oxydation partielle ou totale selon leur épaisseur et la nature des couches qui les entourent, par exemple, au moment du dépôt de la couche suivante ou par oxydation au contact de la couche sous-jacente.

Selon des modes de réalisation avantageux de l'invention, la ou les couches de blocage satisfont une ou plusieurs des conditions suivantes :
- chaque couche métallique fonctionnelle est au contact d'au moins une couche de blocage choisie parmi une sous-couche de blocage et une surcouche de blocage, et/ou
- chaque couche métallique fonctionnelle est au contact d'une surcouche de blocage, et/ou
- l'épaisseur de chaque couche de blocage est d'au moins 0,1 nm, de préférence comprise entre 0,5 et 2,0 nm, et/ou
- l'épaisseur totale de toutes les couches de blocage au contact des couches fonctionnelles est comprise entre 0,5 et 5 nm en incluant ces valeurs, de préférence entre 1 et 3 nm, voire 1 et 2 nm.

Selon l'invention, chaque revêtement diélectrique comprend au moins une couche diélectrique haut indice. On entend par couche haut indice une couche dont l'indice de réfraction est d'au moins 2,15.

Les couches haut indice selon l'invention peuvent être choisies parmi :
- une couche d'oxyde de titane TiO₂ (indice à 500 de 2,45),
- une couche d'oxyde de manganèse MnO (indice à 550 nm de 2,16),
- une couche d'oxyde de tungstène WO₃ (indice à 550 nm de 2,15),
- une couche d'oxyde de niobium Nb₂O₅ (indice à 550 nm de 2,30),
- une couche d'oxyde de bismuth Bi₂O3 (indice à 550 nm de 2,60),
- une couche de nitrure de zirconium Zr₃N₄ (indice à 550 nm de 2,55),
- une couche de nitrure de silicium et de zirconium (indice à 550 nm compris entre 2,20 et 2,25).

Les couches haut indice selon l'invention présentent un indice de réfraction, par ordre de préférence croissant, inférieur ou égal à 2,60, inférieur ou égal à 2,50, inférieur ou égal à 2,40, inférieur ou égal à 2,35, inférieur ou égal à 2,30.

Les revêtements diélectriques peuvent comprendre une ou plusieurs couches haut indice, différentes ou de même nature. De préférence, les couches haut indice sont des couches de nitrure de silicium et de zirconium.

Selon un mode de réalisation, au moins un revêtement diélectrique ne comprend pas de couche diélectrique haut indice à base d'oxyde de titane d'épaisseur optique supérieure à 20 nm. Selon un mode de réalisation, aucun revêtement diélectrique comprend de couche diélectrique haut indice à base d'oxyde de titane d'épaisseur optique supérieure à 20 nm.

Selon des modes de réalisation avantageux de l'invention, les couches diélectrique haut indice des revêtements diélectriques satisfont une ou plusieurs des conditions suivantes en termes d'épaisseurs :
- la somme des épaisseurs optiques de toutes les couches diélectrique haut indice d'un même revêtement diélectrique est dénommée selon le revêtement diélectrique concerné Eohi1, Eohi2, Eohi3 ou Eohi4,
- la somme des épaisseurs optiques de toutes les couches diélectrique haut indice du premier revêtement diélectrique satisfait les relations suivantes, par ordre de préférence croissant, Eoih1/Eo1 > 0,30, Eoih1/Eo1 > 0,40, Eoih1/Eo1 > 0,50, Eoih1/Eo1 > 0,60, Eoih1/Eo1 > 0,70, Eoih1/Eo1 > 0,80, Eoih1/Eo1 > 0,85, et/ou
- la somme des épaisseurs optiques de toutes les couches diélectrique haut indice du premier revêtement diélectrique satisfait les relations suivantes, par ordre de préférence croissant, Eoih1/Eo1 < 0,95, Eoih1/Eo1 < 0,90, et/ou
- la somme des épaisseurs optiques de toutes les couches diélectrique haut indice du deuxième revêtement diélectrique satisfait les relations suivantes, par ordre de préférence croissant, Eoih2/Eo2 > 0,30, Eoih2/Eo2 > 0,40, Eoih2/Eo2 > 0,50, Eoih2/Eo2 > 0,60, Eoih2/Eo2 > 0,70, Eoih2/Eo2 > 0,80, Eoih2/Eo2 > 0,85, et/ou
- la somme des épaisseurs optiques de toutes les couches diélectrique haut indice du deuxième revêtement diélectrique satisfait les relations suivantes, par ordre de préférence croissant, Eoih2/Eo2 < 0,95, Eoih2/Eo2 < 0,90,
- la somme des épaisseurs optiques de toutes les couches diélectrique haut indice du troisième revêtement diélectrique satisfait les relations suivantes, par ordre de préférence croissant, Eoih3/Eo3 > 0,30, Eoih3/Eo3 > 0,40, Eoih3/Eo3 > 0,50, Eoih3/Eo3 > 0,60, Eoih3/Eo3 > 0,70, Eoih3/Eo3 > 0,80, Eoih3/Eo3 > 0,85, et/ou
- la somme des épaisseurs optiques de toutes les couches diélectrique haut indice du troisième revêtement diélectrique satisfait les relations suivantes, par ordre de préférence croissant, Eoih3/Eo3 < 0,95, Eoih3/Eo3 < 0,90,
- la somme des épaisseurs optiques de toutes les couches diélectrique haut indice du quatrième revêtement diélectrique satisfait les relations suivantes, par ordre de préférence croissant, Eoih4/Eo4 > 0,30, Eoih4/Eo4 > 0,40, Eoih4/Eo4 > 0,50, Eoih4/Eo4 > 0,60, Eoih4/Eo4 > 0,70, Eoih4/Eo4 > 0,80, Eoih4/Eo4 > 0,85, et/ou
- la somme des épaisseurs optiques de toutes les couches diélectrique haut indice du quatrième revêtement diélectrique satisfait les relations suivantes, par ordre de préférence croissant, Eoih4/Eo4 < 0,95, Eoih4/Eo4 < 0,90.

Selon des modes de réalisation avantageux de l'invention, les couches diélectrique haut indice des revêtements diélectriques satisfont une ou plusieurs des conditions suivantes :
- au moins un revêtement diélectrique comprend une couche diélectrique haut indice à base de nitrure de silicium et de zirconium,
- au moins deux revêtements diélectriques comprennent une couche diélectrique haut indice à base de nitrure de silicium et de zirconium,
- au moins trois revêtements diélectriques comprennent une couche diélectrique haut indice à base de nitrure de silicium et de zirconium,
- chaque revêtement diélectrique comprend une couche diélectrique haut indice à base de nitrure de silicium et de zirconium.

Lorsque la couche diélectrique haut indice est à base de nitrure de silicium et de zirconium, elle comprend, par ordre de préférence croissant :
- entre 30 et 70 %, entre 40 et 60 %, entre 45 et 55 %, en masse de silicium par rapport à la masse totale de silicium et de zirconium dans la couche haut indice,
- entre 30 et 70 %, entre 40 et 60 %, entre 45 et 55 %, en masse de zirconium par rapport à la masse totale de silicium et de zirconium dans la couche haut indice.

Lorsque la couche diélectrique haut indice est à base de nitrure de silicium et de zirconium, elle comprend, par ordre de préférence croissant :
- entre 50 et 95 %, entre 60 et 90 %, entre 75 et 85 % atomique de silicium par rapport au silicium et au zirconium dans la couche haut indice,
- entre 5 et 50 %, entre 10 et 40 %, entre 15 et 25 % atomique de zirconium par rapport au silicium et au zirconium dans la couche haut indice.

Les couches de silicium et de zirconium peuvent être déposées à partir d'une cible métallique de silicium et de zirconium.

Il est possible de prévoir un autre élément, comme par exemple l'aluminium, par exemple, pour augmenter la conductivité d'une cible à base de silicium et de zirconium. La cible métallique peut donc comprendre en outre de l'aluminium qui se retrouvera alors dans la couche haut indice.

Lorsque la couche diélectrique haut indice comprend en outre de l'aluminium, elle comprend, par ordre de préférence croissant, entre 1 et 10 %, entre 2 et 8 %, entre 3 et 6 %, en masse de aluminium par rapport à la masse totale d'aluminium, de silicium et de zirconium dans la couche haut indice.

Dans ce cas, pour obtenir l'indice souhaité, il est préférable que les proportions en masse par rapport à la masse totale du silicium, du zirconium et de l'aluminium dans la couche haut indice, soient choisies dans les plages suivantes :
- entre 40 % et 60 % de silicium en incluant ces valeurs,
- entre 40 et 60 % de zirconium en incluant ces valeurs,
- entre 1 % et 10 % d'aluminium en incluant ces valeurs.

Selon des modes de réalisation avantageux de l'invention, les revêtements diélectriques satisfont une ou plusieurs des conditions suivantes en termes d'épaisseurs :
- chaque revêtement diélectrique comprend au moins une couche diélectrique haut indice dont l'indice de réfraction est supérieur à 2,15 et dont l'épaisseur optique supérieure à 20 nm.
- les revêtements diélectriques M1, M2, M3 et M4 ont chacun une épaisseur optique Eo1, Eo2, Eo3 et Eo4 satisfaisant la relation suivante : Eo4 < Eo1 < Eo2 < Eo3,
- l'épaisseur optique du premier revêtement diélectrique M1 est, par ordre de préférence croissant, comprise de 60 à 140 nm, de 80 à 120 nm, de 90 à 100 nm, et/ou
- l'épaisseur physique du premier revêtement diélectrique M1 est, par ordre de préférence croissant, comprise de 30 à 60 nm, de 35 à 55 nm, de 35 à 45 nm, et/ou
- l'épaisseur optique du deuxième revêtement diélectrique M2 est, par ordre de préférence croissant, comprise de 120 à 180 nm, de 130 à 170 nm, de 140 à 160 nm, et/ou
- l'épaisseur physique du deuxième revêtement diélectrique M2 est, par ordre de préférence, croissant comprise de 50 à 100 nm, de 60 à 80 nm, de 65 à 75 nm, et/ou
- l'épaisseur optique du troisième revêtement diélectrique M3 est, par ordre de préférence croissant, comprise de 140 à 200 nm, de 150 à 180 nm, de 160 à 170 nm, et/ou
- l'épaisseur physique du troisième revêtement diélectrique M3 est, par ordre de préférence croissant, comprise de 50 à 100 nm, de 65 à 95 nm, de 70 à 80 nm, et/ou
- l'épaisseur optique du quatrième revêtement diélectrique M4 est, par ordre de préférence croissant, comprise de 50 à 120 nm, de 60 à 100 nm, de 70 à 90 nm, et/ou
- l'épaisseur physique du quatrième revêtement diélectrique M4 est, par ordre de préférence croissant, comprise de 20 à 50 nm, de 25 à 45 nm, de 30 à 40 nm, et/ou Selon des modes de réalisation avantageux de l'invention, les revêtements diélectriques satisfont une ou plusieurs des conditions suivantes :
- au moins un revêtement diélectrique comprend en outre au moins une couche diélectrique dont l'indice de réfraction est inférieur à 2,15,
- au moins deux revêtements diélectriques comprend en outre au moins une couche diélectrique dont l'indice de réfraction est inférieur à 2,15,
- au moins trois revêtements diélectriques comprend en outre au moins une couche diélectrique dont l'indice de réfraction est inférieur à 2,15,
- chaque revêtement diélectrique comprend en outre au moins une couche diélectrique dont l'indice de réfraction est inférieur à 2,15,
- les couches diélectriques dont l'indice de réfraction est inférieur à 2,15 peuvent être à base d'oxyde ou de nitrure d'un ou plusieurs éléments choisis parmi le silicium, le zirconium, le titane, l'aluminium, l'étain, le zinc, et/ou
- au moins un revêtement diélectrique comporte au moins une couche diélectrique à fonction barrière, et/ou
- chaque revêtements diélectrique comporte au moins une couche diélectrique à fonction barrière, et/ou
- les couches diélectriques à fonction barrière ont de préférence un indice de réfraction est inférieur à 2,15, et/ou
- les couches diélectriques à fonction barrière sont à base de composés de silicium et/ou d'aluminium choisis parmi les oxydes tels que SiO₂ et Al₂O₃, les nitrures de silicium Si₃N₄ et AIN et les oxynitrures SiOₓN_{y} et AlOₓN_{y}, et/ou
- les couches diélectriques à fonction barrière sont à base de composés de silicium et/ou d'aluminium comprennent éventuellement au moins un autre élément, comme l'aluminium, le hafnium et le zirconium, et/ou
- au moins un revêtement diélectrique comprend au moins une couche diélectrique à fonction stabilisante, et/ou
- chaque revêtement diélectrique comprend au moins une couche diélectrique à fonction stabilisante, et/ou
- les couches diélectriques à fonction stabilisante ont de préférence un indice de réfraction est inférieur à 2,15, et/ou
- les couches diélectriques à fonction stabilisante sont de préférence à base d'oxyde choisi parmi l'oxyde de zinc, l'oxyde d'étain, l'oxyde de zirconium ou un mélange d'au moins deux d'entre eux,
- les couches diélectriques à fonction stabilisante sont de préférence à base d'oxyde cristallisé, notamment à base d'oxyde de zinc, éventuellement dopé à l'aide d'au moins un autre élément, comme l'aluminium, et/ou
- chaque couche fonctionnelle est au-dessus d'un revêtement diélectrique dont la couche supérieure est une couche diélectrique à fonction stabilisante, de préférence à base d'oxyde de zinc et/ou en-dessous d'un revêtement diélectrique dont la couche inférieure est une couche diélectrique à fonction stabilisante, de préférence à base d'oxyde de zinc,
- au moins un revêtement diélectrique situé en dessous d'une couche métallique fonctionnelle comporte au moins une couche diélectrique à fonction de lissage, et/ou
- chaque revêtement diélectrique situé en dessous d'une couche métallique fonctionnelle comporte au moins une couche diélectrique à fonction de lissage, et/ou
- les couches diélectriques à fonction de lissage sont de préférence à base d'oxyde mixte d'au moins deux métaux choisis parmi Sn, Zn, In, Ga,
- les couches diélectriques à fonction de lissage sont de préférence des couches d'oxyde mixte de zinc et d'étain éventuellement dopées,
- les couches diélectriques à fonction de lissage ont de préférence un indice de réfraction est inférieur à 2,15.

De préférence, chaque revêtement diélectrique est constitué uniquement d'une ou de plusieurs couches diélectriques. De préférence, il n'y a donc pas de couche absorbante dans les revêtements diélectriques afin de ne pas diminuer la transmission lumineuse.

Les empilements de l'invention peuvent comprendre des couches diélectriques à fonction barrière. On entend par couches diélectriques à fonction barrière, une couche en un matériau apte à faire barrière à la diffusion de l'oxygène et de l'eau à haute température, provenant de l'atmosphère ambiante ou du substrat transparent, vers la couche fonctionnelle. Les matériaux constitutifs de la couche diélectrique à fonction barrière ne doivent donc pas subir de modification chimique ou structurelle à haute température qui entraînerait une modification de leurs propriétés optiques. La ou les couches à fonction barrière sont de préférence également choisies en un matériau apte à faire barrière au matériau constitutif de la couche fonctionnelle. Les couches diélectriques à fonction barrière permettent donc à l'empilement de subir sans évolution optique trop significative des traitements thermiques du type recuit, trempe ou bombage.

Les empilements de l'invention peuvent comprendre des couches diélectriques à fonction stabilisante. Au sens de l'invention, « stabilisante » signifie que l'on sélectionne la nature de la couche de façon à stabiliser l'interface entre la couche fonctionnelle et cette couche. Cette stabilisation conduit à renforcer l'adhérence de la couche fonctionnelle aux couches qui l'entourent, et de fait elle va s'opposer à la migration de son matériau constitutif.

La ou les couches diélectriques à fonction stabilisante peuvent se trouver directement au contact d'une couche fonctionnelle ou séparées par une couche de blocage.

De préférence, la dernière couche diélectrique de chaque revêtement diélectrique situé en-dessous d'une couche fonctionnelle est une couche diélectrique à fonction stabilisante. En effet, il est avantageux d'avoir une couche à fonction stabilisante, par exemple, à base d'oxyde de zinc en-dessous d'une couche fonctionnelle, car elle facilite l'adhésion et la cristallisation de la couche fonctionnelle à base d'argent et augmente sa qualité et sa stabilité à haute température.

Il est également avantageux d'avoir une couche fonction stabilisante, par exemple, à base d'oxyde de zinc au-dessus d'une couche fonctionnelle, pour en augmenter l'adhésion et s'opposer de manière optimale à la diffusion du côté de l'empilement opposé au substrat.

La ou les couches diélectriques à fonction stabilisantes peuvent donc se trouver au-dessus et/ou en dessous d'au moins une couche fonctionnelle ou de chaque couche fonctionnelle, soit directement à son contact ou soit séparées par une couche de blocage.

Avantageusement, chaque couche diélectrique à fonction barrière est séparée d'une couche fonctionnelle par au moins une couche diélectrique à fonction stabilisante.

Cette couche diélectrique à fonction stabilisante peut avoir une épaisseur d'au moins 4 nm, notamment une épaisseur comprise entre 4 et 10 nm et mieux de 8 à 10 nm.

L'empilement de couches minces peut éventuellement comprendre une couche de lissage. On entend par couches de lissage, une couche dont la fonction est de favoriser la croissance de la couche stabilisante selon une orientation cristallographique préférentielle, laquelle favorise la cristallisation de la couche d'argent par des phénomènes d'épitaxie. La couche de lissage est située en-dessous et de préférence au-contact d'une couche stabilisante.

La couche de lissage à base d'oxyde mixte peut être qualifiée de « non cristallisée » dans le sens où elle peut être complètement amorphe ou partiellement amorphe et ainsi partiellement cristallisée, mais qu'elle ne peut pas être complètement cristallisée, sur toute son épaisseur. Elle ne peut être de nature métallique car elle est à base d'oxyde mixte (un oxyde mixte est un oxyde d'au moins deux éléments).

L'indice de la couche de lissage est, de préférence, inférieur à 2,15. Par ailleurs, la couche de lissage présente de préférence une épaisseur entre 0,1 et 30 nm et de préférence encore comprise entre 0,2 et 10 nm.

L'empilement de couches minces peut éventuellement comprendre une couche de protection. La couche de protection est de préférence la dernière couche de l'empilement, c'est-à-dire la couche la plus éloignée du substrat revêtu de l'empilement. Ces couches supérieures de protection sont considérées comme comprises dans le quatrième revêtement diélectrique. Ces couches ont en général une épaisseur comprise entre 2 et 10 nm, de préférence 2 et 5 nm. Cette couche de protection peut être choisie parmi une couche de titane, de zirconium, d'hafnium, de zinc et/ou d'étain, ce ou ces métaux étant sous forme métallique, oxydée ou nitrurée.

La couche de protection peut par exemple être choisie parmi une couche d'oxyde de titane, une couche d'oxyde de zinc et d'étain ou une couche d'oxyde de titane et de zirconium.

Un mode de réalisation particulièrement avantageux concerne un substrat revêtu d'un empilement défini en partant du substrat transparent comprenant :
- un premier revêtement diélectrique comprenant au moins une couche haut indice, éventuellement une couche à fonction barrière, une couche diélectrique à fonction stabilisante,
- éventuellement une couche de blocage,
- une première couche fonctionnelle,
- éventuellement une couche de blocage,
- un deuxième revêtement diélectrique comprenant au moins un couche diélectrique à fonction stabilisante inférieure, éventuellement une couche à fonction barrière, une couche diélectrique haut indice, éventuellement un couche à fonction de lissage, une couche diélectrique à fonction stabilisante supérieure,
- éventuellement une couche de blocage,
- une deuxième couche fonctionnelle,
- éventuellement une couche de blocage,
- un troisième revêtement diélectrique comprenant au moins un couche diélectrique à fonction stabilisante inférieure, éventuellement une couche à fonction barrière, une couche diélectrique haut indice, éventuellement un couche à fonction de lissage, une couche diélectrique à fonction stabilisante supérieure,
- éventuellement une couche de blocage,
- une troisième couche fonctionnelle,
- éventuellement une couche de blocage,
- un quatrième revêtement diélectrique comprenant au moins une couche diélectrique à fonction stabilisante, éventuellement une couche à fonction barrière, une couche diélectrique haut indice et éventuellement une couche de protection.

Les substrats transparents selon l'invention sont de préférence en un matériau rigide minéral, comme en verre, ou organiques à base de polymères (ou en polymère).

Les substrats transparents organiques selon l'invention peuvent également être en polymère, rigides ou flexibles. Des exemples de polymères convenant selon l'invention comprennent, notamment :
- le polyéthylène,
- les polyesters tels que le polyéthylène téréphtalate (PET), le polybutylène téréphtalate (PBT), le polyéthylène naphtalate (PEN) ;
- les polyacrylates tels que le polyméthacrylate de méthyle (PMMA) ;
- les polycarbonates ;
- les polyuréthanes ;
- les polyamides ;
- les polyimides ;
- les polymères fluorés comme les fluoroesters tels que l'éthylène tétrafluoroéthylène (ETFE), le polyfluorure de vinylidène (PVDF), le polychlorotrifluorethylène (PCTFE), l'éthylène de chlorotrifluorethylène (ECTFE), les copolymères éthylène-propylène fluores (FEP) ;
- les résines photoréticulables et/ou photopolymérisables, telles que les résines thiolène, polyuréthane, uréthane-acrylate, polyester-acrylate et
- les polythiouréthanes.

Le substrat est de préférence une feuille de verre ou de vitrocéramique.

Le substrat est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate.

Le substrat possède avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le matériau, c'est-à-dire le substrat revêtu de l'empilement, peut subir un traitement thermique à température élevée tel qu'un recuit, par exemple par un recuit flash tel qu'un recuit laser ou flammage, une trempe et/ou un bombage. La température du traitement thermique est supérieure à 400 °C, de préférence supérieure à 450 °C, et mieux supérieure à 500 °C. Le substrat revêtu de l'empilement peut donc être bombé et/ou trempé.

L'empilement est de préférence positionné dans le vitrage de sorte que la lumière incidente provenant de l'extérieur traverse le premier revêtement diélectrique avant de traverser la première couche métallique fonctionnelle. L'empilement n'est pas déposé sur la face du substrat définissant la paroi extérieure du vitrage mais sur la face intérieure de ce substrat. L'empilement est donc avantageusement positionné en face 2, la face 1 du vitrage étant la face la plus à l'extérieur du vitrage, comme habituellement.

Le vitrage de l'invention peut être sous forme de vitrage monolithique, feuilleté ou multiple, en particulier double vitrage ou triple vitrage. Le vitrage de l'invention est de préférence un vitrage multiple. Un vitrage multiple comprend au moins un premier et un second substrats transparents parallèles et séparés par une lame de gaz dont au moins l'un des substrats est revêtu d'un empilement de couches minces. Les matériaux selon l'invention conviennent tout particulièrement lorsqu'ils sont utilisés dans des double-vitrages à isolation thermique renforcée (ITR).

Dans le cas d'un vitrage monolithique ou multiple, l'empilement est de préférence déposé en face 2, c'est-à-dire qu'il se trouve sur le substrat définissant la paroi extérieure du vitrage et plus précisément sur la face intérieure de ce substrat.

Un vitrage monolithique comporte 2 faces, la face 1 est à l'extérieur du bâtiment et constitue donc la paroi extérieure du vitrage, la face 2 est à l'intérieur du bâtiment et constitue donc la paroi intérieure du vitrage.

Un double vitrage comporte 4 faces, la face 1 est à l'extérieur du bâtiment et constitue donc la paroi extérieure du vitrage, la face 4 est à l'intérieur du bâtiment et constitue donc la paroi intérieure du vitrage, les faces 2 et 3 étant à l'intérieur du double vitrage.

De la même manière, un triple vitrage comporte 6 faces, la face 1 est à l'extérieur du bâtiment (paroi extérieure du vitrage), la face 6 à l'intérieur du bâtiment (paroi intérieure du vitrage) et les faces 2 à 5 sont à l'intérieur du triple vitrage.

Un vitrage feuilleté comporte au moins une structure de type premier substrat / feuille(s) / deuxième substrat. L'empilement de couches minces est positionné sur l'une au moins des faces d'un des substrats. L'empilement peut être sur la face du deuxième substrat non au contact de la feuille, de préférence polymère. Ce mode de réalisation est avantageux lorsque le vitrage feuilleté est monté en double vitrage avec un troisième substrat.

Le vitrage selon l'invention, utilisé comme vitrage monolithique ou dans un vitrage multiple de type double-vitrage, présente des couleurs en réflexion extérieure neutres, agréables et douces, dans la gamme des bleus ou bleus-verts (valeurs de longueur d'onde dominante de l'ordre de 470 à 500 nanomètres). De plus, cet aspect visuel reste quasiment inchangé quel que soit l'angle d'incidence avec lequel le vitrage est observé (incidence normale et sous angle). Cela signifie qu'un observateur n'a pas l'impression d'une inhomogénéité significative de teinte ou d'aspect.

Par « couleur dans le bleu-vert » au sens de la présente invention, il faut comprendre que dans le système de mesure de couleur L*a*b*, a* est compris entre - 10,0 et 0,0, de préférence entre -5,0 et 0,0 et b* est compris entre -10,0 et 0,0, de préférence entre -5,0 et 0,0.

Selon des modes de réalisation avantageux, le vitrage de l'invention sous forme d'un double vitrage comprenant l'empilement positionné en face 2 permet d'atteindre notamment les performances suivantes :
- un facteur solaire g inférieur ou égal à 34,0 %, de préférence inférieur ou égal à 33,5 %, voire inférieur ou égal à 33,0 % et/ou
- une transmission lumineuse, par ordre de préférence croissant, supérieure à 65 %, supérieure à 67 %, supérieure à 68 %, supérieure à 69 %, de préférence comprise entre 65 % et 75 %, voire comprise entre 67 et 71 % et/ou
- une sélectivité élevée, par ordre de préférence croissant, d'au moins 2,0, d'au moins 2,05, d'au moins 2,1 et/ou
- une réflexion lumineuse côté extérieur inférieure ou égale à 20 %, de préférence inférieur ou égale à 15 %, et/ou
- une réflexion lumineuse côté intérieur inférieure ou égale à 20 %, de préférence inférieur ou égale à 15 %, et/ou
- des couleurs neutres en réflexion extérieure.

Les détails et caractéristiques avantageuses de l'invention ressortent des exemples non limitatifs suivants, illustrés à l'aide de la figure jointe.

Les proportions entre les différents éléments ne sont pas respectées afin de faciliter la lecture des figures.

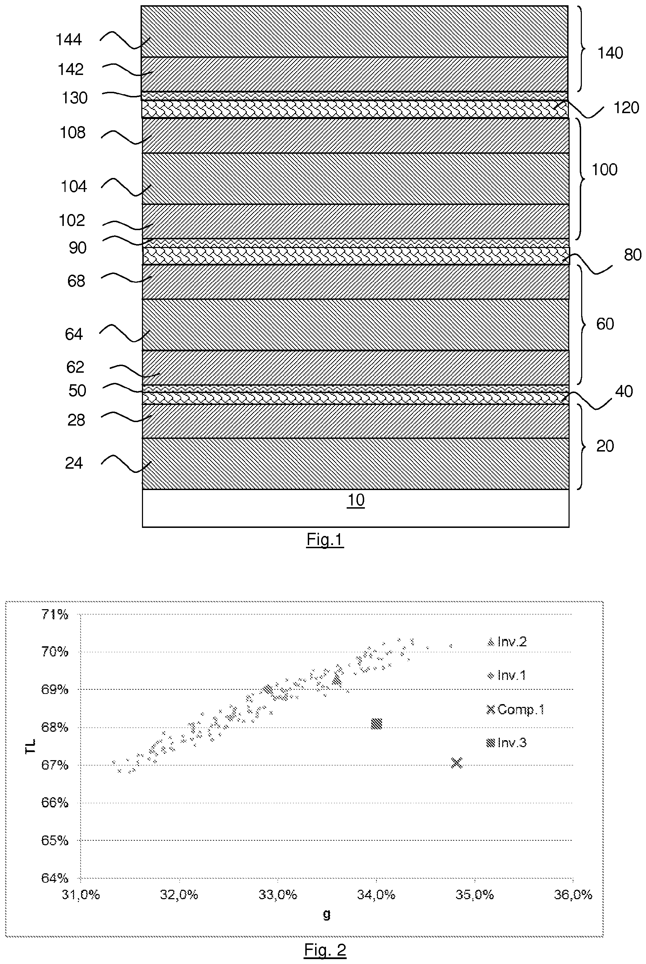

La figure 1 illustre une structure d'empilement à trois couches métalliques fonctionnelles 40, 80, 120, cette structure étant déposée sur un substrat 10 verrier, transparent. Chaque couche fonctionnelle 40, 80, 120 est disposée entre deux revêtements diélectrique 20, 60, 100, 140 de telle sorte que :
- la première couche fonctionnelle 40 en partant du substrat est disposée entre les revêtements diélectrique 20, 60,
- la deuxième couche fonctionnelle 80 est disposée entre les revêtements diélectrique 60, 100 et
- la troisième couche fonctionnelle 120 est disposée entre les revêtements diélectriques 100, 140.

Ces revêtements diélectriques 20, 60, 100, 140 comportent chacun au moins une couche diélectrique 24, 25, 26, 28 ; 62, 63, 64, 66, 68 ; 102, 103, 104, 106, 108 ; 142, 144.

L'empilement peut comprendre également :
- des sous-couches de blocage 30, 70, et 110 (non représentées), 50, 90 et 130 situées au contact d'une couche fonctionnelle,
- des surcouches de blocage 50, 90 et 130 situées au contact d'une couche fonctionnelle,
- une couche de protection (non représentée).

### Exemples

### I. Préparation des substrats : Empilements, conditions de dépôt et traitements thermiques

Des empilements de couches minces définis ci-après sont déposés sur des substrats en verre sodo-calcique clair d'une épaisseur de 6 mm.

Les matériaux selon l'invention et comparatifs ont des couleurs qui satisfont les critères définis dans la « colorbox » référence ci-dessous. Les caractéristiques optiques sont mesurées :
- sur des matériaux sous forme de double vitrage de structure 6/16/4 : verre de 6 mm / espace intercalaire de 16 mm rempli d'argon à 90 % / verre de 4 mm, l'empilement étant positionné en face 2 (la face 1 du vitrage étant la face la plus à l'extérieur du vitrage, comme habituellement),
- sur des matériaux sous forme de simple vitrage avec un substrat de 6 mm et l'empilement étant positionné en face 2.

| **Tab. 1 : « Colorbox » référence** | | | | | | | | | |
|---|---|---|---|---|---|---|---|---|---|
| Double vitrage | | | | | | | | Simple vitrage | |
| a*T | b*T | Rext | a*ext | b*ext | Rint | a*int | b*int | a*g60° | b*p60° |
| -5 | 2 | 12 | -3,5 | -5 | 13 | -3 | -3 | -4,5 | -3 |
| ± 2.0 | ± 1,5 | ± 1 | ± 1 | ± 1,2 | ± 3 | ± 3 | ± 2 | ± 2,2 | ± 2 |

Pour les doubles vitrages,
- a*T et b*T indiquent les couleurs en transmission a* et b* dans le système L*a*b* mesurées selon l'illuminant D65 à 2° Observateur et mesurées perpendiculairement au vitrage ;
- Rext indique : la réflexion lumineuse dans le visible en %, mesurée selon l'illuminant D65 à 2° Observateur du côté de la face la plus à l'extérieur, la face 1 ;
- a*Rext et b*Rext indiquent les couleurs en réflexion a* et b* dans le système L*a*b* mesurées selon l'illuminant D65 à 2° Observateur du côté de la face la plus à l'extérieur et mesurées ainsi perpendiculairement au vitrage,
- Rint indique : la réflexion lumineuse dans le visible en %, mesurée selon l'illuminant D65 à 2° Observateur du côté de la face intérieur, la face 4 ;
- a*Rint et b*Rint indiquent les couleurs en réflexion a* et b* dans le système L*a*b* mesurées selon l'illuminant D65 à 2° Observateur du côté de la face intérieur et mesurées ainsi perpendiculairement au vitrage.

Les valeurs colorimétriques en angle a*g60° et b*g60° sont mesurées sur simple vitrage sous incidence de 60°. Cela rend compte de la neutralité des couleurs en angle.

Dans les exemples de l'invention :
- les couches fonctionnelles sont des couches d'argent (Ag),
- les couches de blocage sont des couches d'oxyde de titane,
- les couches haut indice sont choisies parmi des couches base de nitrure de silicium et de zirconium et des couches d'oxyde de titane,
- les couches barrières sont à base de nitrure de silicium, dopé à l'aluminium (Si₃N₄ : Al),
- les couches stabilisantes sont en oxyde de zinc (ZnO),
- les couches de lissages sont à base d'oxyde mixte de zinc et d'étain (SnZnOx).

Les couches de nitrure de silicium et de zirconium sont déposées à partir d'une cible métallique comprenant du silicium, du zirconium et de l'aluminium.

Les conditions de dépôt des couches, qui ont été déposées par pulvérisation (pulvérisation dite « cathodique magnétron »), sont résumées dans le tableau 2.

| **Tab. 2** | Cible employée | Pression de dépôt | Gaz | n 550 nm |
|---|---|---|---|---|
| Si₃N₄ | Si:Al à 92:8 % en poids | 3,2.10⁻³ mbar | Ar /(Ar + N2) à 55 % | 2,06 |
| SiZrAIN | Si :Al :Zr (70:8:22% at.) | 3,2.10⁻³ mbar | Ar /(Ar + N2) à 55 % | 2,22 |
| ZnO | Zn:Al à 98:2 % en poids | 1,8.10⁻³ mbar | Ar /(Ar + O2) à 63 % | 1,95 |
| SnZnOx | Sn:Zn (60:40% en pds) | 1,5*10⁻³ mbar | Ar 39 % - O₂ 61 % | 2,04 |
| TiOx | TiOx | 1,5*10⁻³ mbar | Ar 88 % - O₂ 12% | 2,45 |
| NiCr | Ni (80% at.) : Cr (20% at.) | 2-3.10⁻³ mbar | Ar à 100 % | - |
| Ag | Ag | 3.10⁻³ mbar | Ar à 100 % | - |

| | | | | |
|---|---|---|---|---|
| At. = atomique. | | | | |

Le tableau 3 liste les matériaux et les épaisseurs physiques en nanomètres (sauf autre indication) de chaque couche ou revêtement qui constitue les empilements en fonction de leur position vis-à-vis du substrat porteur de l'empilement (dernière ligne en bas du tableau). Les numéros « Réf. » correspondent aux références de la figure 1. Chaque revêtement diélectrique 20, 60, 100 en-dessous d'une couche fonctionnelle 40, 80, 120 comporte une dernière couche stabilisante 28, 68, 108 à base d'oxyde de zinc cristallisé, et qui est au contact de la couche fonctionnelle 40, 80, 120 déposée juste au-dessus.

Chaque revêtement diélectrique 60, 100, 140 au-dessus d'une couche fonctionnelle 40, 80, 120 comporte une première couche stabilisante 62, 102, 142 à base d'oxyde de zinc cristallisé, et qui est au contact de la couche fonctionnelle 40, 80, 120 déposée juste au-dessus.

Chaque revêtement diélectrique 20, 60, 100, 140 comporte une couche diélectrique haut indice 24, 64, 104, 144, à base de nitrure de silicium et de zirconium ou d'oxyde de titane.

Les revêtements diélectriques 20, 60, 100, 140 peuvent comporter une couche diélectrique à fonction barrière 25, 63, 103, 143, à base de nitrure de silicium, dopé à l'aluminium appelée ici Si3N4.

Les revêtements diélectriques 20, 60, 100 peuvent comporter en outre une couche de lissage à base d'oxyde mixte de zinc et d'étain 26, 66, 106.

Chaque couche fonctionnelle métallique 40, 80, 120 est en-dessous et au contact d'une couche de blocage 50, 90 et 130.

| **Tab. 3** | Réf. | Inv.1 | Inv.2 | Inv.3 | Comp.1 | Comp.2 | Comp.3 | Comp. 4 |
|---|---|---|---|---|---|---|---|---|
| Revêtement diélectrique M4 | 140 | 38,9 | 34,8 | 31,5 | 41,6 | 38,7 | 50,0 | 50,0 |
| -TiOx | 144 | 0,0 | 0,0 | 23,5 | 0,0 | 0,0 | 0 | 0 |
| - SiZrN | 144 | 14,6 | 29,8 | 0,0 | 0,0 | 14,4 | 40,0 | 40,0 |
| - Si3N4 | 143 | 16,3 | 0,0 | 0,0 | 33,6 | 16,3 | 0,0 | 0,0 |
| -ZnO | 142 | 8,0 | 5,0 | 8,0 | 8,0 | 8,0 | 10,0 | 10,0 |
| Couche blocage NiCr | 130 | 0,5 | 0,5 | 0,5 | 0,5 | 0,5 | 0,1 | 0,1 |
| Couche fonctionnelle Ag3 | 120 | 17,7 | 18,0 | 17,6 | 17,7 | 16,5 | 16 | 18 |
| Couche blocage NiCr | 110 | 0,0 | 0,0 | 0,0 | 0,0 | 0,0 | 0,0 | 0,0 |
| Revêtement diélectrique M3 | 100 | 79,1 | 74,4 | 76,8 | 78,6 | 81,0 | 85,0 | 85,0 |
| -ZnO | 108 | 8,0 | 5,0 | 8,0 | 8,0 | 8,0 | 10,0 | 10,0 |
| - SnZnO | 106 | 8,0 | 0,0 | 0,0 | 0,0 | 0,0 | 6,0 | 6,0 |
| - SiZrN | 104 | 26,3 | 64,4 | 60,8 | 0,0 | 0,0 | 59,0 | 59,0 |
| - Si3N4 | 103 | 28,8 | 0,0 | 0,0 | 62,6 | 65,0 | 0,0 | 0,0 |
| -ZnO | 102 | 8,0 | 5,0 | 8,0 | 8,0 | 8,0 | 10,0 | 10,0 |
| Couche blocage TiOx | 90 | 0,5 | 0,5 | 0,5 | 0,5 | 0,5 | 0,1 | 0,1 |
| Couche fonctionnelle Ag2 | 80 | 14,3 | 14,2 | 13,5 | 11,9 | 13,3 | 16 | 18 |
| Couche blocage NiCr | 70 | 0,0 | 0,0 | 0,0 | 0,0 | 0,0 | 0,0 | 0,0 |
| Revêtement diélectrique M2 | 60 | 71,1 | 67,0 | 72,2 | 65,1 | 72,0 | 87,0 | 87,0 |
| -ZnO | 68 | 8,0 | 5,0 | 8,0 | 8,0 | 8,0 | 10,0 | 10,0 |
| - SnZnO | 66 | 8,0 | 0,0 | 0,0 | 0,0 | 0,0 | 6,0 | 6,0 |
| - SiZrN | 64 | 21,4 | 57,0 | 56,2 | 0,0 | 0,0 | 63,0 | 63,0 |
| - Si3N4 | 63 | 25,7 | 0,0 | 0,0 | 49,1 | 56,0 | 0,0 | 0,0 |
| -ZnO | 62 | 8,0 | 5,0 | 8,0 | 8,0 | 8,0 | 8,0 | 8,0 |
| Couche blocage TiOx | 50 | 0,5 | 0,5 | 0,5 | 0,5 | 0,5 | 0,1 | 0,1 |
| Couche fonctionnelle Ag1 | 40 | 9,6 | 9,5 | 8,8 | 11,0 | 11,1 | 15 | 18 |
| Couche blocage NiCr | 30 | 0,0 | 0,0 | 0,0 | 0,0 | 0,0 | 0,0 | 0,0 |
| Revêtement diélectrique M1 | 20 | 44,4 | 43,1 | 39,3 | 31,8 | 44,4 | 44,0 | 44,0 |
| -ZnO | 28 | 8,0 | 5,0 | 8,0 | 8,0 | 8,0 | 10,0 | 10,0 |
| - SnZnO | 26 | 0,0 | 0,0 | 0,0 | 0,0 | 8,0 | 6,0 | 6,0 |
| - Si3N4 | 25 | 8,0 | 0,0 | 0,0 | 23,8 | 0,0 | 0,0 | 0,0 |
| - SiZrN | 24 | 28,4 | 38,1 | 0,0 | 0,0 | 28,4 | 28,0 | 28,0 |
| -TiOx | 24 | 0,0 | 0,0 | 31,3 | 0,0 | 0,0 | 0,0 | 0,0 |
| Substrat verre (mm) | 10 | 6,0 | 6,0 | 6,0 | 6,0 | 6,0 | 6,0 | 6,0 |

Le tableau 4 résume les caractéristiques liées aux épaisseurs des couches fonctionnelles et des revêtements diélectriques.

| **Tab. 4** | **Inv.1** | | **Inv.2** | | **Inv.3** | | **Comp.1** | | **Comp.2** | | **Comp.3** | | **Comp.4** | |
|---|---|---|---|---|---|---|---|---|---|---|---|---|---|---|
| RD | Ep | Eo | Ep | Eo | Ep | Eo | Ep | Eo | Ep | Eo | Ep | Eo | Ep | Eo |
| M1 | 44,4 | 95,1 | 43,1 | 94,3 | 39,3 | 92,3 | 31,8 | 64,6 | 44,4 | 95,0 | 44,0 | 91,2 | 44,0 | 91,2 |
| M2 | 71,1 | 148,0 | 67 | 146,0 | 72,2 | 156,0 | 65,1 | 132,3 | 72 | 146,6 | 87,0 | 181, 7 | 87,0 | 181,7 |
| M3 | 79,1 | 165,2 | 74,4 | 162,5 | 76,8 | 166,2 | 78,6 | 160,2 | 81 | 165,1 | 85,0 | 176, 8 | 85,0 | 176,8 |
| M4 | 38,9 | 81,1 | 34,8 | 75,9 | 31,5 | 73,2 | 41,6 | 83,8 | 38,7 | 80,7 | 50,0 | 105 | 50,0 | 105 |
| Ag2/Ag1 | 1,49 | | 1,49 | | 1,53 | | 1,08 | | 1,20 | | 1,07 | | 1,00 | |
| Ag3/Ag2 | 1,24 | | 1,27 | | 1,30 | | 1,49 | | 1,24 | | 1,00 | | 1,00 | |
| Ag1+Ag2+Ag3 | 41,60 | | 41,70 | | 39,90 | | 40,60 | | 40,85 | | 47 | | 54 | |
| M1 Eohi1/EO1 | 0,66 | | 0,90 | | 0,83 | | 0,00 | | 0,66 | | 0,66 | | 0,66 | |
| M2 Eohi2/EO1 | 0,32 | | 0,87 | | 0,81 | | 0,00 | | 0,00 | | 0,72 | | 0,72 | |
| M3 Eohi3/EO1 | 0,35 | | 0,88 | | 0,81 | | 0,00 | | 0,00 | | 0,72 | | 0,72 | |
| M4 Eohi4/EO1 | 0,40 | | 0,87 | | 0,79 | | 0,00 | | 0,40 | | 0,82 | | 0,82 | |
| Σ Ep CB | 1,50 | | 1,50 | | 1,50 | | 1,50 | | 1,50 | | 0,30 | | 0,30 | |

| | | | | | | | | | | | | | | |
|---|---|---|---|---|---|---|---|---|---|---|---|---|---|---|
| RD : Revêtement diélectrique ; CB : Couche de blocage ; Ep : Epaisseur physique ; Eo : Epaisseur optique. | | | | | | | | | | | | | | |

### II. Performances « contrôle solaire »

Le tableau 5 liste les performances énergétiques obtenues lorsque les vitrages font parties de double vitrage tels que décrits ci-dessus.

| **Tab. 5** | **Valeur cible** | **Inv.1** | **Inv.2** | **Inv.3** | **Comp.1** | **Comp.2** | **Comp. 3** | **Comp. 4** |
|---|---|---|---|---|---|---|---|---|
| « g » % | ≤ 34,0 % | 32,9 | 33,6 | 34,0 | 34,82 | 34,35 | 28,4 | 23,5 |
| « s » | > 2,00 | 2,10 | 2,06 | 2,00 | 1,93 | 1,99 | 2,26 | 2,5 |
| TL% | ≈ 70 % | 69,0 | 69,3 | 68,1 | 67,06 | 68,4 | 64,4 | 58,9 |

Dans le premier mode de réalisation (Inv.1), chaque revêtement diélectrique M1 à M4 comprend une couche haut indice à base de nitrure de silicium et de zirconium.

Dans le second mode de réalisation (Inv.2), chaque revêtement diélectrique M1 à M4 comprend une couche haut indice à base de nitrure de silicium et de zirconium et le rapport de l'épaisseur optique de cette couche haut indice sur l'épaisseur optique du revêtement diélectrique la contenant est supérieure à 0,5, de préférence supérieur à 0,8. Les meilleures performances sont obtenues pour cet exemple.

Dans le troisième mode de réalisation (Inv.3), les revêtements diélectriques M1 et M4 comprennent des couches haut-indice à base de TiO2 et les revêtements diélectriques M2 et M3 comprennent des couches haut-indice à base de nitrure de silicium et de zirconium. Les performances sont moins intéressantes que lorsque tous les revêtements diélectriques sont à base de SiZrN, mais meilleures que celles obtenues avec pour les exemples comparatifs 1 et 2,

Dans l'exemple comparatif 1, aucun revêtement diélectrique M1 à M4 ne comprend de couche haut indice d'épaisseur optique supérieure à 20 nm.

Dans l'exemple comparatif 2, les revêtements diélectriques M1 et M4 ne comprennent pas de couche haut indice d'épaisseur optique supérieure à 20 nm et les revêtements diélectriques M2 et M3 contiennent des couches haut indice à base de nitrure de silicium et de zirconium. Les performances sont moins bonnes que celles obtenues pour les matériaux de l'invention dont chaque revêtement diélectrique comprend une couche haut indice.

La figure 2 résume les performances atteintes avec les différents exemples. Un nuage de point est donné pour illustrer la gamme de performances accessibles, tout en conservant les couleurs dans la colorbox de référence, avec les matériaux de type Inv.1 et Inv.2, c'est-à-dire des matériaux comprenant dans chaque revêtement diélectrique une couche haut indice à base de nitrure de silicium et de zirconium.

Selon l'invention, il est possible de réaliser un vitrage comprenant un empilement à trois couches fonctionnelles métalliques qui présente une transmission lumineuse d'environ 70 %, une sélectivité élevée, une réflexion lumineuse et un facteur solaire faible. Les vitrages selon l'invention présentent à la fois un facteur solaire inférieur ou égal à 34 % et une sélectivité supérieure à 2,00. Ces vitrages présentent en plus une réflexion extérieure au moins inférieure à 15 %.

Les exemples selon l'invention présentent tous une coloration en transmission agréable et douce, de préférence dans la gamme des bleus ou bleus-verts.

La solution proposée permet donc d'atteindre les performances suivantes :
- une transmission lumineuse d'environ 70 %,
- un facteur solaire d'environ 33 %,
- une faible réflexion côte extérieur et
- une esthétique neutre.

## Revendications

1. Matériaux comprenant un substrat transparent revêtu d'un empilement de couches minces comportant successivement à partir du substrat une alternance de trois couches métalliques fonctionnelles à base d'argent dénommées en partant du substrat première, deuxième et troisième couches fonctionnelles, les épaisseurs des couches métalliques fonctionnelles en partant du substrat augmentent en fonction de l'éloignement du substrat, et de quatre revêtements diélectriques dénommés en partant du substrat M1, M2, M3 et M4, chaque revêtement diélectrique comportant au moins une couche diélectrique, de manière à ce que chaque couche métallique fonctionnelle soit disposée entre deux revêtements diélectriques, **caractérisé en ce que** :
- les revêtements diélectriques M1, M2, M3 et M4 ont chacun une épaisseur optique Eo1, Eo2, Eo3 et Eo4,
- chaque revêtement diélectrique comprend au moins une couche diélectrique haut indice dont l'indice de réfraction est d'au moins 2,15 et dont l'épaisseur optique supérieure à 20 nm,
- la somme des épaisseurs optiques de toutes les couches diélectrique haut indice d'un même revêtement diélectrique est dénommée selon le revêtement diélectrique concerné Eohi1, Eohi2, Eohi3 ou Eohi4
- chaque revêtement diélectrique satisfait la relation suivante : Eohi1/Eo1 > 0,30,
Eohi2/Eo2 > 0,30,
Eohi3/Eo3 > 0,30,
Eohi4/Eo4 > 0,30,
- le rapport de l'épaisseur de la deuxième couche métallique sur l'épaisseur de la première couche métallique fonctionnelle est compris entre 1,20 et 2,00, en incluant ces valeurs, et
- le rapport de l'épaisseur de la troisième couche métallique sur l'épaisseur de la deuxième couche métallique fonctionnelle est compris entre 1,20 et 1,80, en incluant ces valeurs.

2. Matériau selon la revendication 1 **caractérisé en ce que** le rapport de l'épaisseur de la deuxième couche métallique sur l'épaisseur de la première couche métallique fonctionnelle est compris entre 1,40 et 2,00, en incluant ces valeurs.

3. Matériau selon l'une des revendications précédentes, **caractérisé en ce que** l'empilement comprend en outre au moins une couche de blocage située au contact d'une couche fonctionnelle choisies parmi les couches métalliques, les couches de nitrure métallique, les couches d'oxyde métallique et les couches d'oxynitrure métallique d'un ou plusieurs éléments choisis parmi le titane, le nickel, le chrome et le niobium telles qu'une couche de Ti, TiN, TiO₂ Nb, NbN, Ni, NiN, Cr, CrN, NiCr, NiCrN.

4. Matériau selon l'une quelconque des revendications précédentes, **caractérisé en ce que** les revêtements diélectriques M1, M2, M3 et M4 ont chacun une épaisseur optique Eo1, Eo2, Eo3 et Eo4 satisfaisant la relation suivante : Eo4 < Eo1 < Eo2 < Eo3.

5. Matériau selon l'une des revendications précédentes, **caractérisé en ce que** les couches haut indice présentent un indice de réfraction inférieur ou égal à 2,35.

6. Matériau selon l'une des revendications précédentes, **caractérisé en ce que** chaque revêtement diélectrique satisfait la relation suivante : Eohi1/Eo1 > 0,80,
Eohi2/Eo2 > 0,80,
Eohi3/Eo3 > 0,80,
Eohi4/Eo4 > 0,80.

7. Matériau selon l'une quelconque des revendications précédentes, **caractérisé en ce qu'**au moins deux revêtements diélectriques comprennent une couche diélectrique haut indice à base de nitrure de silicium et de zirconium.

8. Matériau selon l'une quelconque des revendications précédentes, **caractérisé en ce que** chaque revêtement diélectrique comprend une couche diélectrique haut indice à base de nitrure de silicium et de zirconium.

9. Matériau selon l'une quelconque des revendications précédente, **caractérisé en ce que** les revêtements diélectriques satisfont les caractéristiques suivantes :
- l'épaisseur optique du premier revêtement diélectrique M1 est comprise de 60 à 140 nm,
- l'épaisseur optique du deuxième revêtement diélectrique M2 est comprise de 120 à 180 nm,
- l'épaisseur optique du troisième revêtement diélectrique M3 est comprise de 140 à 200 nm,
- l'épaisseur optique du quatrième revêtement diélectrique M4 est comprise de 50 à 120 nm.

10. Matériau selon l'une quelconque des revendications précédentes caractérisé en ce chaque revêtement diélectrique comprend en outre au moins une couche diélectrique dont l'indice de réfraction est inférieur à 2,15.

11. Matériau selon l'une quelconque des revendications précédentes, **caractérisé en ce qu'**il comprend un empilement défini en partant du substrat transparent comprenant :
- un premier revêtement diélectrique comprenant au moins une couche haut indice, éventuellement une couche à fonction barrière, une couche diélectrique à fonction stabilisante,
- éventuellement une couche de blocage,
- une première couche fonctionnelle,
- éventuellement une couche de blocage,
- un deuxième revêtement diélectrique comprenant au moins un couche diélectrique à fonction stabilisante inférieure, éventuellement une couche à fonction barrière, une couche diélectrique haut indice, éventuellement un couche à fonction de lissage, une couche diélectrique à fonction stabilisante supérieure,
- éventuellement une couche de blocage,
- une deuxième couche fonctionnelle,
- éventuellement une couche de blocage,
- un troisième revêtement diélectrique comprenant au moins un couche diélectrique à fonction stabilisante inférieure, éventuellement une couche à fonction barrière, une couche diélectrique haut indice, éventuellement un couche à fonction de lissage, une couche diélectrique à fonction stabilisante supérieure,
- éventuellement une couche de blocage,
- une troisième couche fonctionnelle,
- éventuellement une couche de blocage,
- un quatrième revêtement diélectrique comprenant au moins une couche diélectrique à fonction stabilisante, éventuellement une couche à fonction barrière, une couche diélectrique haut indice et éventuellement une couche de protection.

12. Procédé d'obtention d'un matériau selon l'une des revendications précédentes, dans lequel on dépose les couches de l'empilement par pulvérisation cathodique magnétron.

13. Vitrage comprenant au moins un matériau selon l'une des revendications de matériau précédentes.

14. Vitrage selon la revendication précédente **caractérisé en ce que** l'empilement est positionné dans le vitrage de sorte que la lumière incidente provenant de l'extérieur traverse le premier revêtement diélectrique avant de traverser la première couche métallique fonctionnelle.

15. Vitrage selon l'une quelconque des revendications précédentes, caractérisé en qu'il est sous forme de vitrage multiple, en particulier double vitrage ou triple vitrage.

## Patentansprüche

1. Materialien, die ein transparentes Substrat umfassen, das mit einem Stapel dünner Schichten beschichtet ist, die ausgehend vom Substrat nacheinander einen Wechsel von drei metallischen Funktionsschichten auf der Basis von Silber umfassen, die ausgehend vom Substrat erste, zweite und dritte Funktionsschicht genannt werden, wobei die Dicken der metallischen Funktionsschichten ausgehend vom Substrat mit zunehmendem Abstand vom Substrat zunehmen, und vier dielektrische Beschichtungen, ausgehend vom Substrat M1, M2, M3 und M4 genannt, wobei jede dielektrische Beschichtung mindestens eine dielektrische Schicht umfasst, sodass jede metallische Funktionsschicht zwischen zwei dielektrischen Beschichtungen angeordnet ist, **dadurch gekennzeichnet, dass**:
- die dielektrischen Beschichtungen M1, M2, M3 und M4 jeweils eine optische Dicke Eo1, Eo2, Eo3 und Eo4 aufweisen,
- jede dielektrische Beschichtung mindestens eine dielektrische Schicht mit hohem Index umfasst, deren Brechungsindex mindestens 2,15 beträgt und deren optische Dicke größer als 20 nm ist,
- die Summe der optischen Dicken aller dielektrischen Schichten mit hohem Index einer selben dielektrischen Beschichtung gemäß der betreffenden dielektrischen Beschichtung Eohi1, Eohi2, Eohi3 oder Eohi4 genannt ist,
- jede dielektrische Beschichtung die folgende Beziehung erfüllt: Eohi1/Eo1 > 0,30,
Eohi2/Eo2 > 0,30,
Eohi3/Eo3 > 0,30,
Eohi4/Eo4 > 0,30,
- das Verhältnis der Dicke der zweiten metallischen Schicht zur Dicke der ersten metallischen Funktionsschicht zwischen 1,20 und 2,00 beträgt, einschließlich dieser Werte, und
- das Verhältnis der Dicke der dritten metallischen Schicht zur Dicke der zweiten metallischen Funktionsschicht zwischen 1,20 und 1,80 beträgt, einschließlich dieser Werte.

2. Material nach Anspruch 1 **dadurch gekennzeichnet, dass** das Verhältnis der Dicke der zweiten metallischen Schicht zur Dicke der ersten metallischen Funktionsschicht zwischen 1,40 und 2,00 beträgt, einschließlich dieser Werte.

3. Material nach einem der vorhergehenden Ansprüche, **dadurch gekennzeichnet, dass** der Stapel ferner mindestens eine Blockierschicht umfasst, die in Kontakt mit einer Funktionsschicht liegt, die aus metallischen Schichten, metallischen Nitridschichten, metallischen Oxidschichten und metallischen Oxynitridschichten aus einem oder mehreren Elementen ausgewählt sind, ausgewählt aus Titan, Nickel, Chrom und Niob, wie eine Schicht aus Ti, TiN, TiO₂Nb, NbN, Ni, NiN, Cr, CrN, NiCr, NiCrN.

4. Material nach einem der vorhergehenden Ansprüche, **dadurch gekennzeichnet, dass** die dielektrischen Beschichtungen M1, M2, M3 und M4 jeweils eine optische Dicke Eo1, Eo2, Eo3 und Eo4 aufweisen, die die folgende Beziehung erfüllt: Eo4 < Eo1 < Eo2 < Eo3.

5. Material nach einem der vorhergehenden Ansprüche, **dadurch gekennzeichnet, dass** die Schichten mit hohem Index einen Brechungsindex von weniger als oder gleich 2,35 aufweisen.

6. Material nach einem der vorhergehenden Ansprüche, **dadurch gekennzeichnet, dass** jede dielektrische Beschichtung die folgende Beziehung erfüllt: Eohi1/Eo1 > 0,80,
Eohi2/Eo2 > 0,80,
Eohi3/Eo3 > 0,80,
Eohi4/Eo4 > 0,80.

7. Material nach einem der vorhergehenden Ansprüche, **dadurch gekennzeichnet, dass** mindestens zwei dielektrische Beschichtungen eine dielektrische Schicht mit hohem Index auf der Basis von Siliciumnitrid und Zirkonium umfassen.

8. Material nach einem der vorhergehenden Ansprüche, **dadurch gekennzeichnet, dass** jede dielektrische Beschichtung eine dielektrische Schicht mit hohem Index auf der Basis von Siliciumnitrid und Zirkonium umfasst.

9. Material nach einem der vorhergehenden Ansprüche, **dadurch gekennzeichnet, dass** die dielektrischen Beschichtungen die folgenden Merkmale erfüllen:
- die optische Dicke der ersten dielektrischen Beschichtung M1 beträgt von 60 bis 140 nm,
- die optische Dicke der zweiten dielektrischen Beschichtung M2 beträgt von 120 bis 180 nm,
- die optische Dicke der dritten dielektrischen Beschichtung M3 beträgt von 140 bis 200 nm,
- die optische Dicke der vierten dielektrischen Beschichtung M4 beträgt von 50 bis 120 nm.

10. Material nach einem der vorhergehenden Ansprüche, **dadurch gekennzeichnet, dass** jede dielektrische Beschichtung ferner mindestens eine dielektrische Schicht umfasst, deren Brechungsindex weniger als 2,15 beträgt.

11. Material nach einem der vorhergehenden Ansprüche, **dadurch gekennzeichnet, dass** es einen ausgehend vom transparenten Substrat definierten Stapel umfasst, umfassend:
- eine erste dielektrische Beschichtung, umfassend mindestens eine Schicht mit hohem Index, gegebenenfalls eine Schicht mit Barrierefunktion, eine dielektrische Schicht mit stabilisierender Funktion,
- gegebenenfalls eine Blockierschicht,
- eine erste Funktionsschicht,
- gegebenenfalls eine Blockierschicht,
- eine zweite dielektrische Beschichtung, umfassend mindestens eine dielektrische Schicht mit einer niedrigeren Stabilisierungsfunktion, gegebenenfalls eine Schicht mit Barrierefunktion, eine dielektrische Schicht mit hohem Index, gegebenenfalls eine Schicht mit Glättungsfunktion, eine dielektrische Schicht mit einer höheren Stabilisierungsfunktion,
- gegebenenfalls eine Blockierschicht,
- eine zweite Funktionsschicht,
- gegebenenfalls eine Blockierschicht,
- eine dritte dielektrische Beschichtung, umfassend mindestens eine dielektrische Schicht mit einer niedrigeren Stabilisierungsfunktion, gegebenenfalls eine Schicht mit Barrierefunktion, eine dielektrische Schicht mit hohem Index, gegebenenfalls eine Schicht mit Glättungsfunktion, eine dielektrische Schicht mit einer höheren Stabilisierungsfunktion,
- gegebenenfalls eine Blockierschicht,
- eine dritte Funktionsschicht,
- gegebenenfalls eine Blockierschicht,
- eine vierte dielektrische Beschichtung, umfassend mindestens eine dielektrische Schicht mit Stabilisierungsfunktion, gegebenenfalls eine Schicht mit Barrierefunktion, eine dielektrische Schicht mit hohem Index und gegebenenfalls eine Schutzschicht.

12. Verfahren zum Erhalten eines Materials nach einem der vorhergehenden Ansprüche, wobei die Schichten des Stapels durch Magnetron-Kathodenzerstäubung abgeschieden werden.

13. Verglasung, umfassend mindestens ein Material nach einem der vorhergehenden Ansprüche des Materials.

14. Verglasung nach dem vorhergehenden Anspruch, **dadurch gekennzeichnet, dass** der Stapel in der Verglasung so positioniert ist, dass das von außen kommende, einfallende Licht die erste dielektrische Beschichtung durchquert, bevor es die erste metallische Funktionsschicht durchquert.

15. Verglasung nach einem der vorhergehenden Ansprüche, **dadurch gekennzeichnet, dass** sie in Form einer Mehrfachverglasung, insbesondere einer Doppelverglasung oder Dreifachverglasung, vorliegt.

## Claims

1. Materials comprising a transparent substrate coated with a stack of thin layers successively comprising, starting from the substrate, an alternation of three silver-based functional metal layers denoted, starting from the substrate, first, second and third functional layers, the thicknesses of the functional metal layers, starting from the substrate, increase as a function of the distance from the substrate, and of four dielectric coatings denoted, starting from the substrate, M1, M2, M3 and M4, each dielectric coating comprising at least one dielectric layer, so that each functional metal layer is positioned between two dielectric coatings, **characterized in that**:
- the dielectric coatings M1, M2, M3 and M4 each have an optical thickness To1, To2, To3 and To4,
- each dielectric coating comprises at least one high-index dielectric layer, the refractive index of which is at least 2.15 and the optical thickness of which is greater than 20 nm,
- the sum of the optical thicknesses of all the high-index dielectric layers of one and the same dielectric coating is denoted, according to the dielectric coating concerned, Tohi1, Tohi2, Tohi3 or Tohi4,
- each dielectric coating satisfies the following relationship: Tohi1/To1 > 0.30,
Tohi2/To2 > 0.30,
Tohi3/To3 > 0.30,
Tohi4/To4 > 0.30,
- the ratio of the thickness of the second metal layer to the thickness of the first functional metal layer is between 1.20 and 2.00, including these values, and/or
- the ratio of the thickness of the third metal layer to the thickness of the second functional metal layer is between 1.20 and 1.80, including these values.

2. The material as claimed in claim 1, **characterized in that**:
- the ratio of the thickness of the second metal layer to the thickness of the first functional metal layer is between 1.40 and 2.00, including these values.

3. The material as claimed in one of the preceding claims, **characterized in that** the stack additionally comprises at least one blocking layer located in contact with a functional layer, which layers are chosen from metal layers, metal nitride layers, metal oxide layers and metal oxynitride layers of one or more elements chosen from titanium, nickel, chromium and niobium, such as a Ti, TiN, TiO₂, Nb, NbN, Ni, NiN, Cr, CrN, NiCr or NiCrN layer.

4. The material as claimed in any one of the preceding claims, **characterized in that** the dielectric coatings M1, M2, M3 and M4 each have an optical thickness To1, To2, To3 and To4 satisfying the following relationship: To4 < To1 < To2 < To3.

5. The material as claimed in one of the preceding claims, **characterized in that** the high-index layers exhibit a refractive index of less than or equal to 2.35.

6. The material as claimed in one of the preceding claims, **characterized in that** each dielectric coating satisfies the following relationship: Tohi1/To1 > 0.80,
Tohi2/To2 > 0.80,
Tohi3/To3 > 0.80,
Tohi4/To4 > 0.80.

7. The material as claimed in any one of the preceding claims, **characterized in that** at least two dielectric coatings comprise a high-index dielectric layer based on zirconium silicon nitride.

8. The material as claimed in any one of the preceding claims, **characterized in that** each dielectric coating comprises a high-index dielectric layer based on zirconium silicon nitride.

9. The material as claimed in any one of the preceding claims, **characterized in that** the dielectric coatings satisfy the following characteristics:
- the optical thickness of the first dielectric coating M1 is from 60 to 140 nm,
- the optical thickness of the second dielectric coating M2 is from 120 to 180 nm,
- the optical thickness of the third dielectric coating M3 is from 140 to 200 nm,
- the optical thickness of the fourth dielectric coating M4 is from 50 to 120 nm.

10. The material as claimed in any one of the preceding claims, **characterized in that** each dielectric coating additionally comprises at least one dielectric layer, the refractive index of which is less than 2.15.

11. The material as claimed in any one of the preceding claims, **characterized in that** it comprises a stack, defined starting from the transparent substrate, comprising:
- a first dielectric coating comprising at least one high-index layer, optionally a layer having a barrier function, a dielectric layer having a stabilizing function,
- optionally a blocking layer,
- a first functional layer,
- optionally a blocking layer,
- a second dielectric coating comprising at least one lower dielectric layer having a stabilizing function, optionally a layer having a barrier function, a high-index dielectric layer, optionally a layer having a smoothing function, an upper dielectric layer having a stabilizing function,
- optionally a blocking layer,
- a second functional layer,
- optionally a blocking layer,
- a third dielectric coating comprising at least one lower dielectric layer having a stabilizing function, optionally a layer having a barrier function, a high-index dielectric layer, optionally a layer having a smoothing function, an upper dielectric layer having a stabilizing function,
- optionally a blocking layer,
- a third functional layer,
- optionally a blocking layer,
- a fourth dielectric coating comprising at least one dielectric layer having a stabilizing function, optionally a layer having a barrier function, a high-index dielectric layer and optionally a protective layer.

12. A process for obtaining a material as claimed in one of the preceding claims, in which the layers of the stack are deposited by magnetron cathode sputtering.

13. A glazing comprising at least one material as claimed in one of the preceding material claims.

14. The glazing as claimed in the preceding claim, **characterized in that** the stack is positioned in the glazing so that the incident light originating from the outside passes through the first dielectric coating before passing through the first functional metal layer.

15. The glazing as claimed in any one of the preceding claims, **characterized in that** it is in the form of a multiple glazing, in particular double glazing or triple glazing.
